Europäisches Patentamt

European Patent Office

Office européen des brevets

(11) Veröffentlichungsnummer: **0 249 729 B1**

# (12) EUROPÄISCHE PATENTSCHRIFT

(45) Veröffentlichungstag der Patentschrift: **11.09.91**

(51) Int. Cl.⁵: **H03F 1/30**

(21) Anmeldenummer: **87106547.0**

(22) Anmeldetag: **06.05.87**

(54) Schaltungsanordnung zur automatischen Einstellung des Ruhestromes in einer Gegentaktendstufe.

(30) Priorität: 23.05.86 DE 3617477
20.09.86 DE 3632076

(43) Veröffentlichungstag der Anmeldung:
**23.12.87 Patentblatt 87/52**

(45) Bekanntmachung des Hinweises auf die
Patenterteilung:
**11.09.91 Patentblatt 91/37**

(84) Benannte Vertragsstaaten:
**AT BE CH DE ES FR GB IT LI LU NL SE**

(56) Entgegenhaltungen:
**DE-A- 2 822 037**
**FR-A- 2 055 958**
**US-A- 3 889 202**
**US-A- 4 207 475**

(73) Patentinhaber: **Deutsche Thomson-Brandt GmbH**
**Hermann-Schwer-Strasse 3 Postfach 1307**
**W-7730 Villingen-Schwenningen(DE)**

(72) Erfinder: **Schmitz, Friedrich**
**Sebastian-Kneipp-Strasse 24**
**W-7730 Villingen-Schwenningen(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung geht aus von einer Schaltungsanordnung zur automatischen Einstellung des Ruhestromes in einer transformatorlosen transistorisierten Gegentaktendstufe, an deren Ausgang eine Lastimpedanz nach Bezugspotential geschaltet ist, sowie mit mindestens einem Fühlelement zur Messung des in der Gegentaktendstufe fließenden Ruhestromes.

Eine derartige Schaltung ist bekannt und in der DE-C-33 43 110 beschrieben. Diese Schaltung besitzt jedoch einen Nachteil, indem die zur Messung des Ruhestromes erhaltene Spannung auf die symmetrischen Betriebsspannung +UB und -UB bezogen wird, wodurch eine verhältnismäßig hohe Betriebsspannungsfestigkeit der Bauelemente benötigt wird.

Es ist auch eine nach dem Oberbegriff des Patentanspruchs beschriebene Schaltungsanordnung zur Regelung des Arbeitspunktes bei einem Gegentakt-B-Verstärker bekannt. Dazu wird in einem Zweig der Gegentakt-B-Verstärkerstufe ein nichtlinearer Widerstand als Fühlelement geschaltet, an welchem eine Spannung abgreifbar ist, die über zwei Regeltransistoren den Ruhestrom der Gegentaktendstufe regelt (DE-B-28 22 037).

In der US-A-4,207,475 wird ein bipolar geregeltes Netzteil mit zwei im Gegentakt angeordneten Transistoren beschrieben. Es ist in den Kollektor-Emitter-Strecken der Transistoren je ein Fühlwiderstand vorgesehen, an welchem je eine gegen das Bezugspotential gemessene Spannung abgreifbar ist. Diese Spannungen gelangen über einen Differenzverstärker an eine weitere Differenzverstärkerstufe, deren Ausgang den Basisstrom eines der bipolaren Transistoren regelt. Außerdem ist eine zweite Regelschleife vorgesehen, über die der Laststrom des geregelten Netzteils direkt erfaßt wird. Eine derartige Anordnung ist aber nicht für Frequenzen im Audiofrequenzbereich von NF-Verstärkerstufen geeignet, weil durch Phasenverschiebungen der aus den beiden Detektionskreisen stammenden Spannungen eine unkorrekte Regelung erzeugt wird.

Der Erfindung liegt die Aufgabe zugrunde, eine universelle Auswertbarkeit der gemessenen Spannungen zur Ermittlung des fliessenden Ruhestroms zu erhalten. Diese Aufgabe wird durch die im Patentanspruch angegebene Lehre gelöst. Weitere vorteilhafte Ausgestaltungen der Erfindung ergeben sich aus den Unteransprüchen. Durch die Erfindung wird eine absolute Ruhestromstabilisierung erreicht.

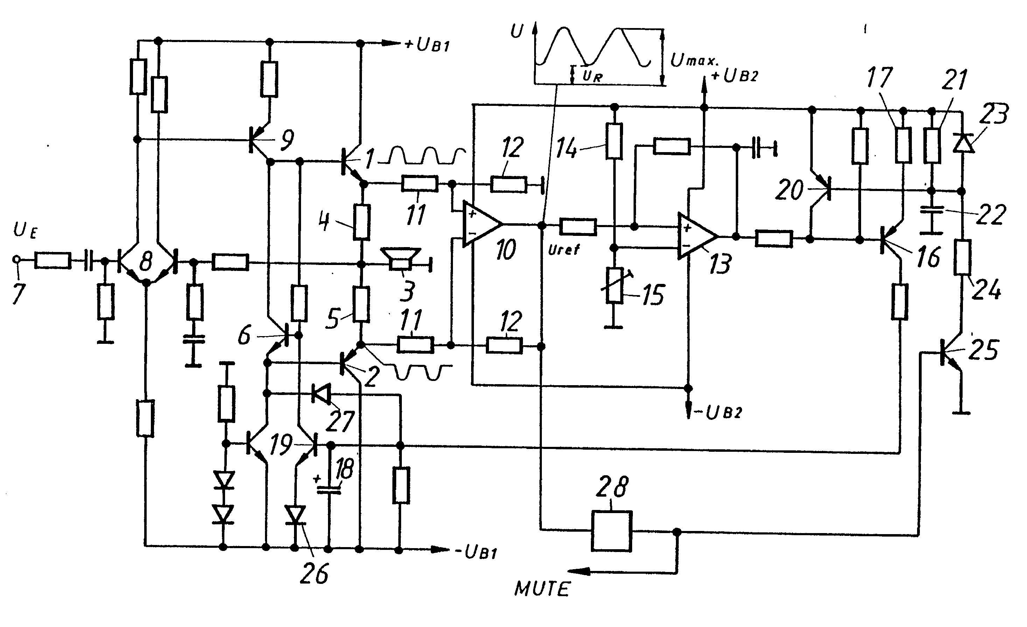

Nachstehend wird die Erfindung mit Hilfe der Zeichnung an einem Ausführungsbeispiel beschrieben.

Es handelt sich bei der Schaltungsanordnung um den Aufbau einer bekannten Gegentaktendstufe mit den komplementären mit ihren Emittern zusammengeschalteten Endtransistoren 1 und 2, deren Kollektoren mit dem Betriebsspannungspotential +UB1 bzw. -UB1 verbunden sind. Die Lastimpedanz 3, z.B. in Form eines Lautsprechers, ist an den Ausgang der Gegentaktendstufe angeschlossen. Das andere Ende der Lastimpedanz ist mit einem Bezugspotential z.B. Masse verbunden. Zwecks Einstellung des in der Gegentaktendstufe fliessenden Ruhestromes dient ein zwischen die Basen der Endtransistoren 1 und 2 eingeschalteter Transistor 6. Über den Anschluß 7 wird das Eingangssignal UE zugeführt, welches über den Vorverstärker 8 und den Treibertransistor 9 die Gegentaktendstufe ansteuert. An den Widerständen 4 und 5 sind gegen das Bezugspotential gemessene Spannungen abgreifbar. Die an dem Widerstand 4 abgegriffene Spannung, die durch den Ruhestrom und den diesem überlagerten durch die Lastimpedanz 3 fliessenden Laststrom gebildet wird, wird dem nichtinvertierenden Eingang einer Differenzverstärkerstufe 10 und die am Widerstand 5 abgegriffene Spannung dem invertierenden Eingang der Differenzverstärkerstufe 10 zugeführt. Am Ausgang der Differenzverstärkerstufe 10 entsteht ein Signal, wie es in der Figur eingezeichnet ist. Es setzt sich zusammen aus dem Wert UR, der dem Ruhestrom, und dem Wert US, der dem Signalstrom entspricht.

Durch die Zuführung des negativen Signalanteils an den invertierenden Eingang der Differenzverstärkerstufe 10 erscheint dieser am Ausgang um 180° phasengedreht. Da die Versorgungsspannung UB2 für die Differenzverstärkerstufe 10 meistens kleiner ist als die Versorgungsspannung UB1 für die Gegentaktendstufe, muß die der Differenzverstärkerstufe 10 zugeführte Signalspannung um einen Teilungsfaktor heruntergesetzt werden, der dem Verhältnis der Widerstandswerte der Widerstände (R11 + R12) / R11 entspricht. Die Differenzverstärkerstufe 10 besitzt einen Verstärkungsgrad V = R12/R11. Die Ausgangsspannung wird dem einen Eingang einer Komparatorschaltung 13 zugeleitet, deren anderer Eingang auf ein Referenzpotential $U_{ref}$ gelegt ist, das mit Hilfe des an die Betriebsspannungsquelle UB2 gelegten Spannungsteilers aus den Widerständen 14 und 15 gebildet wird. Wenn der am Plus-Eingang des Komparators 13 anliegende Spannungswert das am Minus-Eingang anliegende Referenzpotential $U_{ref}$ unterschreitet, geht der Ausgang des Komparators 13 auf Bezugspotential. Der Komparator 13 besitzt einen Open-Kollektor-Ausgang, der entweder Bezugspotential oder die Betriebsspannung UB2 annimmt. Wenn der Ausgang auf das Bezugspotential absinkt, wird ein elektronischer Schalter in Form eines Transistors 16 durchlässig, so daß die Betriebsspannung UB2 über den Widerstand 17 einen elektrischen Speicher in Form eines Kondensators 18 auflädt, der über einen Regeltransistor 19 den Transistor 6 derart beeinflußt, daß der Ruhestrom solange ansteigt, bis der dem Plus-Eingang des Komparators 13 zugeführte Spannungswert dem Referenzpotential $U_{ref}$ entspricht. Das Referenzpotential $U_{ref}$ ist derart eingestellt, daß es dem Spannungsabfall an den Widerständen 4 und 5 entspricht, der dem gewünschten Ruhestrom durch die Gegentaktendstufe proportional ist. Wenn dieser Spannungswert erreicht ist, wird durch das am Ausgang des Komparators 13 entstehende Potential der Transistor 16 gesperrt. Durch die Schaltung erfolgt eine Nachladung des Kondensators 18 nur während der Nulldurchgänge des Eingangssignals UE, zu Zeiten, wenn der tatsächliche Ruhestrom fliesst.

Die Schaltungsanordnung zur automatischen Ruhestromregelung muß jedoch in ihrer Wirkung unter bestimmten, nachfolgend beschriebenen Bedingungen ausgeschaltet sein, was mit zusätzlichen Schaltungsmitteln erreicht wird.

Drei Betriebszustände des Verstärkers erzwingen eine Abschaltung der automatischen Ruhestromregelung.

Beim Ein- und Ausschalten des Verstärkers darf die Ruhestromregelung nicht sofort wirken, da sonst die Endtransistoren zerstört würden. Deshalb ist während des Einschaltvorgangs ein Zeitglied vorgesehen, welches aus einer Reihenschaltung aus einem Widerstand 21 und aus einem Kondensator 22 besteht, das zwischen die Betriebsspannungsquelle UB2 und Bezugspotential geschaltet ist. Der Kondensator 22 liegt an der Steuerelektrode eines elektronsichen Schalters 20 der die Betriebsspannungsquelle UB2 an die Steuerelektrode des elektronischen Schalters 16 legt und diesen sperrt, so lange, bis der Kondensator 22 voll aufgeladen ist. Beim Ausschalten des Verstärkers entlädt sich der Kondensator 22 sehr schnell über die leitende Diode 23 gegen die Betriebsspannungsquelle UB2, so daß der elektronische Schalters 16 gesperrt wird und die Regelung nicht mehr arbeiten kann.

Der Verstärker besitzt einen weiteren Schutz gegen Überlast. In diesem Fall gelangt ein Signal an eine Überlastdetektorschaltung 28 und erzeugt ein Mute-Signal, welches den Verstärker durch Kurzschliessen des Eingangssignals stumm steuert. Dadurch fliesst kein Ruhestrom mehr. Die automatische Ruhestromregelung versucht nun den erforderlichen Ruhestrom wieder einzustellen, d.h. der elektrische Speicher 18 wird unnötigerweise nachgeladen. Bei Fortfall der Überlast würde der dann viel zu hoch eingestellte Ruhestrom die Endtransistoren zerstören. Um das zu verhindern wird aus dem Mute-Signal eine Steuerspannung abgeleitet, die in diesem Fall einen dritten elektronischen Schalter 25 durchschaltet, der den Kondensator 22 über den Widerstand 24 sehr schnell entlädt, so daß der elektronische Schalter 16 sofort gesperrt wird und kein Ladestrom für den elektrischen Speicher 18 liefern kann.

Bei Übersteuerung der Endstufe im Leerlauf fällt an der Kollektor-Emitter-Strecke des Transistors 6 keine Spannung mehr ab. Deshalb fliesst kein Ruhestrom. Die Ruhestromregelung versucht auch in diesem Fall den elektrischen Speicher 18 nachzuladen, so daß bei Zurücknahme der Übersteuerung die Endtransistoren zerstört würden. Deshalb ist in die Emitterleitung des Transistors 19 eine Diode 26 mit einer derart großen Durchlaßspannung geschaltet, daß sie zusammen mit der Basis-Emitter-Strecke UBE am Transistor 19 ein Potential am elektrischen Speicher 18 bildet. Der elektrische Speicher 18 wird bei Übersteuerung über eine Diode 27 entladen, wenn dieses Potential am Kollektor des Treibertransistors 9 unterschritten wird. Die Diode 26 kann je nach Erfordernis zwecks Einstellung des gewünschten Potentials auch aus einer Reihenschaltung aus mehreren Dioden bestehen.

## Patentansprüche

1. Schaltungsanordnung zur automatischen Einstellung des Ruhestromes in einer transformatorlosen transistorisierten Gegentaktendstufe (1, 2), an deren Ausgang eine Lastimpedanz (3) nach Bezugspotential geschaltet ist, sowie mit mindestens einem Fühlelement (4, 5) zur Messung des in der Gegentaktendstufe (1, 2) fliessenden Ruhestromes, **dadurch gekennzeichnet,** daß in jedem Zweig der Gegentaktendstufe (1, 2) je ein Fühlelement (4, 5) vorgesehen ist, an welchem je eine gegen das Bezugspotential gemessene Spannung abgreifbar ist, die auf je einen Eingang einer Differenzverstärkerstufe (10) geschaltet sind, deren Ausgang an den einen Eingang einer Komparatorschaltung (13) geschaltet ist, deren anderer Eingang auf einem Referenpotential ($U_{ref}$) liegt, und daß der Ausgang der Komparatorschaltung (13) einen elektrischen Schalter (16) in der Weise steuert, daß er einen elektrischen Speicher (18) auflädt, dessen Ladespannung den Ruhestrom der Gegentaktendstufe (1, 2) über einen Regeltransistor (19) derart regelt, daß der durch die Fühlelemente (4, 5) gemessene dem Ruhestromwert proportionale Spannungswert mit dem Referenzpotential ($U_{ref}$) übereinstimmt.

2. Schaltungsanordnung nach Anspruch 1, **dadurch gekennzeichnet,** daß die Steuerung des elektronischen Schalters (16) während der Null-Durchgänge des der Gegentaktendstufe (1, 2) zugeführten Eingangssignals erfolgt.

3. Schaltungsanordnung nach Anspruch 1, **dadurch gekennzeichnet,** daß ein zweiter gesteuerter elektronischer Schalter (20) vorgesehen ist, der den ersten gesteuerten elektronischen Schalter (16) während des Einschaltvorgangs der Endstufe sperrt und daß an die Steuerelektrode des zweiten gesteuerten elektronischen Schalters (20) ein Zeitglied (21, 22) geschaltet ist.

4. Schaltungsanordnung nach Anspruch 3, **dadurch gekennzeichnet,** daß das Zeitglied aus einem mit der Betriebsspannungsquelle der Schaltungsanordnung (UB2) verbundenen Widerstand (21) und einem in Serie zu dem Widerstand (21) mit dem Bezugspotential verbundenen Kondensator (22) besteht und der Verbindungspunkt von Widerstand (21) und Kondensator (22) mit der Steuerelektrode des zweiten gesteuerten elektronischen Schalters (20) verbunden ist.

5. Schaltungsanordnung nach Anspruch 4, **dadurch gekennzeichnet,** daß der Verbindungspunkt von Widerstand (21) und Kondensator (22) mit der Betriebsspannungsquelle (UB2) über eine in Durchlassrichtung gepolte Diode (23) verbunden ist.

6. Schaltungsanordnung nach den Ansprüchen 1 und 3, **dadurch gekennzeichnet,** daß der zweite gesteuerte elektronische Schalter (20) in durchgeschaltetem Zustand die Betriebsspannungsquelle (UB2) mit der Steuerelektrode des gesteuerten elektronischen Schalters (16) verbindet.

7. Schaltungsanordnung nach den Ansprüchen 3 und 4, **dadurch gekennzeichnet,** daß der Verbindungspunkt von Widerstand (21) und Kondensator (22) über einen Widerstand (24) und einem dritten gesteuerten elektronischen Schalter (25) mit dem Bezugspotential verbunden ist, an dessen Steuerelektrode ein bei Übersteuerung der Gegentaktendstufe erzeugtes Signal angelegt ist.

8. Schaltungsanordnung nach Anspruch 1, **dadurch gekennzeichnet,** daß in die Emitterleitung des Regeltransistors (19) eine Diode (26) geschaltet ist.

9. Schaltungsanordnung nach Anspruch 1, **dadurch gekennzeichnet,** daß der elektrische Speicher (18) in Durchlaßrichtung über eine Diode (27) wechselstrommäßig mit dem Kollektor des Treibertransistors (9) verbunden ist.

**Claims**

1. Circuit arrangement for the automatic adjustment of the quiescent current in a transformerless transistorised push-pull output stage (1, 2) at whose output a load impedance (3) is connected to reference potential, and with at least one sensing element (4, 5) for measuring the quiescent current flowing in the push-pull output stage (1, 2), characterised in that in each arm of the push-pull output stage (1, 2) a sensing element (4, 5) is provided at which a voltage measured against the reference potential can be picked off, the voltages being connected to respective inputs of a differential amplifier stage (10) whose output is connected to the one input of a comparator circuit (13) whose other input lies at a reference potential ($U_{ref}$), and that the output of the comparator circuit (13) controls an electric switch (16) in such a way that it charges an electrical storage means (18) whose load voltage regulates the quiescent current of the push-pull output stage (1, 2) via a control transistor (19) so that the voltage value proportional to the quiescent flow value and measured by the sensing elements (4, 5) coincides with the reference potential ($U_{ref}$).

2. Circuit arrangement according to claim 1, **characterised in that** the control of the electronic switch (16) takes place during the zero passes of the input signal supplied to the push-pull end stage (1, 2).

3. Circuit arrangement according to claim 1, **characterised in that** a second controlled electronic switch (20) is provided, which blocks the first controlled electronic switch (16) during the switching-on operation of the output stage and that a timing circuit (21, 22) is connected to the control electrode of the second controlled electronic switch (20).

4. Circuit arrangement according to claim 3, **characterised in that** the timing circuit consists of a resistor (21) connected to the operating voltage source of the circuit arrangement (UB2) and a capacitor (22) connected in series with the resistor (21) to the reference potential and the connection point of resistor (21) and capacitor (22) is connected to the control electrode of the second controlled electronic switch (20).

**5.** Circuit arrangement according to claim 4, **characterised in that** the connection point of resistor (21) and capacitor (22) is connected to the operating voltage source (UB2) via a forward-biased diode (23).

**6.** Circuit arrangement according to claims 1 and 3, **characterised in that** the second controlled electronic switch (20) connects, in the connected-through state, the operating voltage source (UB2) to the control electrode of the controlled electronic switch (16).

**7.** Circuit arrangement according to claims 3 and 4, **characterised in that** the connection point of resistor (21) and capacitor (22) is connected via a resistor (24) and a third controlled electronic switch (25) to the reference potential, to whose control electrode a signal generated in the event of overload of the push-pull output stage is applied.

**8.** Circuit arrangement according to claim 1, **characterised in that** a diode (26) is connected into the emitter line of the control transistor (19).

**9.** Circuit arrangement according to claim 1, **characterised in that** the electrical storage means (18) is connected in forward direction via a diode (27) in a.c. mode to the collector of the drive transistor (9).

**Revendications**

**1.** Montage pour le réglage automatique du courant de repos dans un étage final symétrique (1, 2) transistorisé sans transformateur à la sortie duquel est montée une impédance de charge (3) reliée au potentiel de référence ainsi qu'avec au moins un élément capteur (4, 5) pour mesurer le courant de repos qui passe dans l'étage final symétrique (1, 2), **caractérisé en ce** que, dans chaque branche de l'étage final symétrique (1, 2), il est prévu respectivement un élément capteur (4, 5) sur lequel respectivement une tension mesurée par rapport au potentiel de référence peut être prise, tensions qui sont montées sur chacune des entrées d'un étage amplificateur différenciateur (10) dont la sortie est montée sur l'une des entrées d'un circuit comparateur (13) dont l'autre entrée est appliquée à un potentiel de référence (U$_{ref}$) et que la sortie du circuit comparateur (13) excite un commutateur électrique (16) de manière à ce qu'il charge un accumulateur électrique (18) dont la tension de charge règle le courant de repos de l'étage amplificateur différenciateur (1, 2) par un transistor de réglage (19) de telle manière que la valeur de la tension proportionnelle à la valeur du courant de repos mesurée par les éléments capteurs (4, 5) coïncide avec le potentiel de référence (U$_{ref}$).

**2.** Montage selon la revendication 1, **caractérisé en ce** que la commande du commutateur électronique (16) est effectuée pendant les passages à zéro du signal d'entrée amené à l'étage final symétrique (1, 2).

**3.** Montage selon la revendication 1, **caractérisé en ce** qu'un second commutateur électronique commandé (20) est prévu qui bloque le premier commutateur électronique commandé (16) pendant l'opération de mise en circuit de l'étage final et qu'un relais temporisateur (21, 22) est monté sur l'électrode de commande du second commutateur électronique commandé (20).

**4.** Montage selon la revendication 3, **caractérisé en ce** que le relais temporisateur se compose d'une résistance (21) reliée à la source de tension de fonctionnement du montage (UB2) et d'un condensateur (22) relié au potentiel de référence en série avec la résistance (21) et que le point de connexion de la résistance (21) et du condensateur (22) est relié à l'électrode de commande du second commutateur électronique commandé (20).

**5.** Montage selon la revendication 4, **caractérisé en ce** que le point de connexion de la résistance (21) et du condensateur (22) est relié à une source de tension de fonctionnement (UB2) par une diode (23) polarisée dans le sens passant.

**6.** Montage selon les revendications 1 et 3, **caractérisé en ce** que le second commutateur électronique commandé (20) à l'état connecté relie la source de tension de fonctionnement (UB2) à l'électrode de commande du commutateur électronique commandé (16).

**7.** Montage selon les revendications 3 et 4, **caractérisé en ce** que le point de connexion de la résistance (21) et du condensateur (22) est relié au potentiel de référence par une résistance (24) et un troisième commutateur électronique commandé (25) à l'électrode de commande duquel est appliqué un signal produit lors de la saturation de l'étage final symétrique.

8. Montage selon la revendication 1, **caractérisé en ce** qu'une diode (26) est montée dans la ligne émetteur du transistor de réglage (19).

9. Montage selon la revendication 1, **caractérisé en ce** que l'accumulateur électrique (18) est relié dans le sens passant par une diode (27) en courant alternatif au collecteur du transistor d'attaque (9).